# FASCICULE DE BREVET EUROPEEN

(11) **EP 0 740 416 B1**
(45) Date de publication et mention de la délivrance du brevet: **20.01.1999**
(21) Numéro de dépôt: 96400897.3
(22) Date de dépôt: 25.04.1996
(51) Int. Cl.: H03K 17/945

(54) **Détecteur de proximité à apprentissage**
Lernfähiger Näherungsschalter
Learning proximity detector

(30) Priorité: 28.04.1995 FR 9505253
(43) Date de publication de la demande: 30.10.1996
(73) Titulaire: SCHNEIDER ELECTRIC SA, 92100 Boulogne Billancourt (FR)
(72) Inventeur: Brault, Christophe, 16430 Champniers (FR); Durand, Patrick, 16170 Rouillac (FR); Even, Stéphane, 16000 Angoulème (FR)
(74) Mandataire: Carias, Alain

(56) Documents cités:
- EP-A- 0 090 182
- DE-A- 4 331 555
- DE-C- 4 123 828
- US-A- 3 833 850

## Description

La présente invention concerne un détecteur de proximité du type inductif, photoélectrique, ou de tout autre type, comprenant un organe capteur apte à délivrer un signal analogique de détection en fonction de la distance d'une cible et un circuit électronique de traitement relié à un étage de sortie qui délivre un signal de présence ou d'absence de cible selon que la distance de celle-ci est inférieure ou supérieure à une distance de commutation.

La distance de commutation propre à un tel détecteur varie d'un appareil à l'autre et, pour un même appareil, varie selon ses conditions de montage ou son environnement, en particulier lorsqu'il s'agit d'un détecteur inductif noyé dans une masse métallique ou d'une cellule photoélectrique opérant avec un arrière-plan brillant.

Il serait donc utile de pouvoir étalonner le détecteur de proximité sur son site d'utilisation.

Il a déjà été proposé (voir document DE-43 31 555) d'étalonner un détecteur de proximité en usine ou chez l'utilisateur par l'usage d'une logique de commande à laquelle sont connectés une mémoire non volatile et un compteur. Un objet est placé à une distance fixe prédéterminée du détecteur et, quand la logique est sollicitée par un signal d'étalonnage, le comptage se déclenche ; la valeur de comptage, après passage dans un convertisseur numérique-analogique, est comparée à la valeur du signal de détection ; dès qu'elle a atteint cette valeur, le comptage est arrêté et la valeur correspondante mémorisée. Un tel dispositif ne peut cependant pas fonctionner avec une cible en défilement lors de la phase d'étalonnage.

L'invention a pour but de déterminer, d'une manière fiable et autorisant une grande souplesse d'adaptation au site d'utilisation, l'étalonnage du point de basculement d'un détecteur de proximité grâce à une analyse dynamique du mouvement de la cible à détecter.

Elle a aussi pour but de permettre d'étalonner le détecteur quelle que soit la position initiale, distante ou proche, de la cible en mouvement grâce à une analyse dynamique de ce mouvement.et, éventuellement, de réétalonner de même le détecteur en cours d'exploitation.

Selon l'invention, le circuit de traitement comporte des moyens de numérisation du signal analogique et des moyens d'acquisition et de calcul inclus dans une logique commandée par un signal d'apprentissage, les moyens d'acquisition et de calcul étant mis en oeuvre dans une phase d'apprentissage et saisissant au début de la phase d'apprentissage une valeur initiale vₒ du signal numérique de détection significative d'une position initiale d'une cible déplaçable, et au cours de la phase d'apprentissage une valeur extrémale vₘ dudit signal, significative d'une position intermédiaire de la cible ; la logique détermine la fin de la phase d'apprentissage quand la valeur du signal de détection atteint une valeur qui est significative du retour de la cible à une position proche de la position initiale et les moyens d'acquisition et de calcul calculent la valeur de commutation v_{c} en fonction de la valeur initiale vₒ et de la valeur extrémale v_{m,} de préférence en fonction de leur différence et du signe de celle-ci.

Le début de la phase d'apprentissage est engendré à compter de la première application de la tension d'alimentation au détecteur, de préférence avec une légère temporisation, et peut aussi l'être par un signal externe de commande appliqué à une borne du détecteur, les mises sous tension ultérieures ne modifiant pas l'étalonnage déjà réalisé.

De préférence, la logique de traitement comprend des moyens de validation qui d'une part déterminent la fin de la phase d'apprentissage et valident l'étalonnage lorsque le signal de détection atteint une valeur finale voisine de la valeur initiale et d'autre part invalident l'étalonnage lorsque la valeur extrémale reste comprise dans une zone aveugle.

La description qui suit d'un mode de réalisation non limitatif, en regard des dessins annexés, illustre les caractéristiques et avantages de l'invention.
- la figure 1 illustre par un schéma synoptique un détecteur de proximité conforme à l'invention.
- la figure 2 est un diagramme représentant la variation du signal analogique de détection au cours d'une opération d'apprentissage, dans le cas où la cible est distante au début de l'apprentissage.
- la figure 3 est un diagramme similaire dans le cas d'une cible proche en début d'apprentissage.
- la figure 4 est un logigramme de fonctionnement du détecteur.
- la figure 5 montre un logigramme de calcul différenciant une cible initialement proche d'une cible initialement distante.

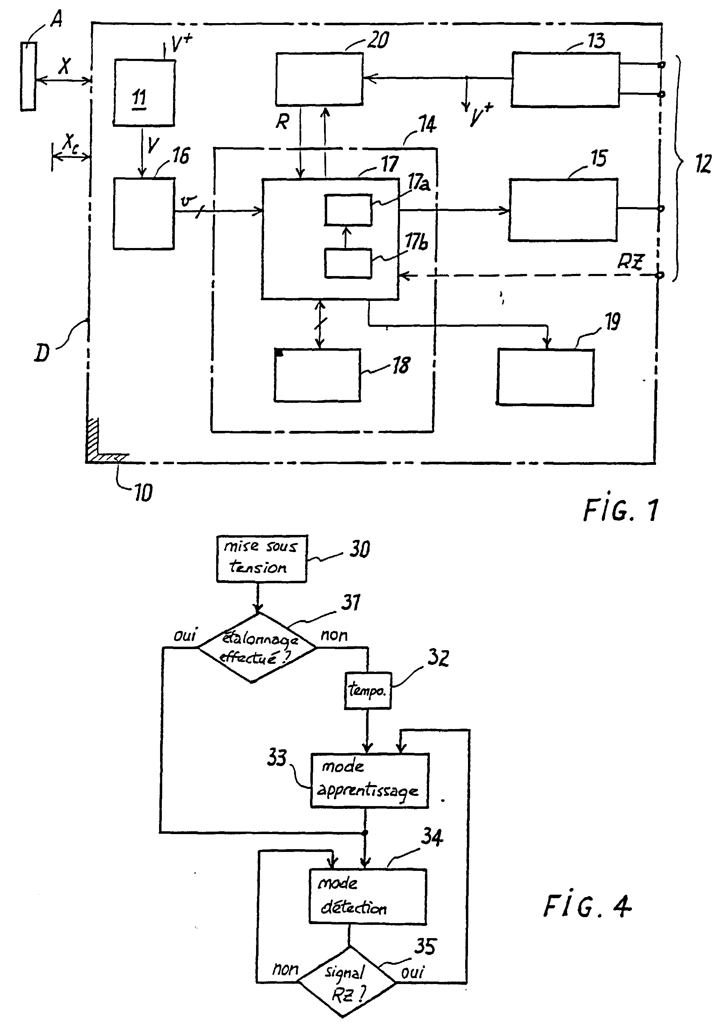

Le détecteur de proximité D illustré sur la figure 1 comprend dans un boîtier 10 un organe capteur 11 qui peut être de tout type usuel ; inductif, capacitif, photoélectrique, à ultrasons ou analogue et qui délivre une grandeur de détection analogique, dans le présent exemple une tension V, dont la valeur est indicative de la distance X d'un objet ou cible A.

Le boîtier 10 du détecteur comprend des bornes 12 de liaison externe avec une source d'énergie et avec une charge, ainsi qu'éventuellement avec un dispositif externe de commande d'étalonnage. Dans le boîtier sont de plus prévus un organe d'alimentation 13, un circuit électronique de traitement 14 et un étage de sortie 15. L'organe d'alimentation 13 fournit à partir de la tension externe une tension V⁺ d'alimentation de l'organe capteur et des tensions d'alimentation pour les autres éléments du détecteur. A l'entrée du circuit électronique de traitement 14 sont associés des moyens de numérisation 16, par exemple un convertisseur analogique-numérique, qui transforment la tension analogique fournie par l'organe capteur en un signal numérique v. Le circuit de traitement 14 comporte une logique de traitement 17 et une mémoire non volatile et réinscriptible 18, par exemple du type EEPROM ou analogue.

La valeur numérique v issue du convertisseur 16 est appliquée en entrée à la logique 17. Celle-ci est par exemple constituée par une logique câblée, un micro-contrôleur ou un microprocesseur et elle est reliée à la mémoire EEPROM 18 pour notamment y écrire et lire une valeur numérique de référence correspondant à la distance de commutation.

Le détecteur de proximité et, en particulier, sa logique de traitement 17, sont conçus pour fonctionner selon un mode d'apprentissage, pendant lequel sera mémorisée la valeur de commutation propre au détecteur in situ, et un mode de détection, pendant lequel sera lue cette même valeur.

Par "mode apprentissage", on désigne présentement un mode de fonctionnement dans lequel le détecteur, concurremment à un défilement de la cible, c'est-à-dire à une phase d'approche puis d'éloignement - ou d'éloignement puis d'approche - de la cible, saisit au cours de cette phase plusieurs valeurs numériques de détection caractéristiques de la cible et détermine en fonction de celles-ci la valeur numérique de commutation v_{c} qui est stockée dans la mémoire 18. Dans le mode détection, le détecteur échantillonne la valeur numérique et la compare à la valeur mémorisée pour délivrer le signal d'absence ou de présence de cible.

La logique de traitement est reliée à un organe de visualisation 19, par exemple constitué par au moins une diode électroluminescente, apte à donner une indication lumineuse différenciée en mode apprentissage et en mode détection. L'organe d'alimentation 13 est relié à un circuit d'initialisation 20 lui-même relié à la logique 17 pour délivrer à celle-ci un signal de reset R initialisant la phase d'apprentissage quand la tension d'alimentation est appliquée pour la première fois au détecteur. D'une autre manière, et comme illustré en tirets sur la figure 1, l'initialisation de la phase d'apprentissage par la logique de traitement peut être causée en cours d'exploitation par l'application d'un signal de remise à zéro RZ à l'une des bornes 12 reliée à la logique et connectée à un conducteur ou bus externe.

La logique de traitement 17 comprend des moyens 17a d'acquisition et de calcul de diverses valeurs numériques et des moyens 17b de validation de certaines de ces valeurs. La logique est enfin reliée à l'étage de sortie 15 pour délivrer à celui-ci un signal, lequel est amplifié en signal de sortie S disponible aux bornes 12. Comme déjà indiqué, suivant la valeur relative de v par rapport à v_{c} en mode détection, le signal S a donc un premier niveau lorsque la distance X de la cible A est supérieure à une distance de commutation X_{c} et un second niveau lorsque X<X_{c}.

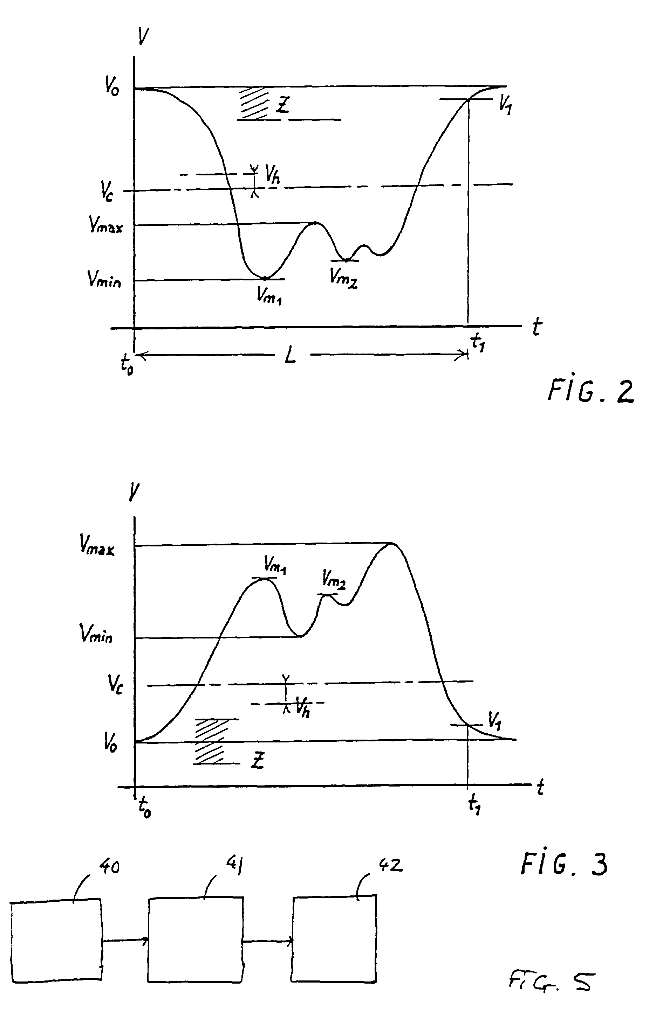

Sur les figures 2 et 3 sont illustrés deux modes d'apprentissage, respectivement avec absence et présence de cible au début de la phase d'apprentissage. Ces figures sont des graphes donnant la variation de la tension analogique V délivrée par l'organe capteur 11 en fonction du temps t. Les valeurs numériques correspondantes sont désignées par v affectée de l'indice respectif.

Dans les deux cas, les moyens de détermination 17a saisissent d'une part à l'instant tₒ une valeur numérique initiale vₒ (tension Vo) lorsque le signal de reset R ou de remise à zéro RZ a été appliqué à la logique de traitement 17, d'autre part au cours de la phase d'apprentissage une valeur numérique d'extremum vₘ mesurée ou calculée, puis déterminent la valeur numérique de commutation v_{c} en fonction de l'amplitude différentielle d'apprentissage vₒ-vₘ.

Dans le mode d'apprentissage de la figure 2, la cible A étant initialement distante, l'organe capteur 11 délivre initialement une tension maximale Vₒ. La cible A se rapproche puis s'éloigne, de sorte que la tension diminue jusqu'à une valeur minimale Vₘᵢₙ puis remonte à sa valeur initiale Vₒ. Selon les cas, la valeur d'extremum Vₘ caractéristique de l'apprentissage est prise égale à la valeur minimale numérique Vₘᵢₙ correspondante ou, si la courbe de variation V(t) présente une ou plusieurs bosses dues à un déplacement non uniforme de la cible, égale à la plus grande valeur maximale Vₘₐₓ intermédiaire entre deux valeurs minimales Vₘ₁, Vₘ₂ ou encore à une combinaison appropriée de ces valeurs. La fin t₁ de la phase d'apprentissage est déterminée lorsque la tension remonte à une valeur de seuil V₁ voisine de Vₒ et légèrement inférieure à Vₒ, par exemple de l'ordre de 2 %, de manière à parer aux problèmes d'échauffement et de dérive ; la valeur numérique correspondante et désignée par v₁.

La valeur numérique de commutation v_{c} est calculée par la logique 17 de préférence selon une fonction appropriée de l'amplitude différentielle vₒ-vₘ, ou selon une fonction linéaire k₁vₒ-k₂vₘ de la valeur initiale et de la valeur d'extremum, pour être mémorisée dans la mémoire 18. Une valeur d'hystérésis vₕ est aussi calculée par la logique 17, en tant que fonction de l'amplitude différentielle, par exemple O,1 (vₒ-vₘ), ou en tant que fraction de v_{c}, cette valeur étant également mémorisée dans la mémoire 18. Il va de soi que la mémoire 18 peut stocker les valeurs indiquées ou les valeurs ou paramètres nécessaires à leur calcul.

Un seuil calé sur la valeur initiale Vₒ définit une zone aveugle d'étalonnage Z telle que, si l'une au moins des valeurs acquises ou calculées dans la phase d'apprentissage (vₘᵢₙ, vₘₐₓ ou v_{c}) est comprise dans cette zone, les moyens de validation 17b invalident l'étalonnage.

Dans le mode d'apprentissage de la figure 3, la cible A est initialement proche du détecteur, de sorte que l'organe capteur fournit une valeur Vₒ minimale dès le début tₒ de la phase d'apprentissage. La cible A s'éloigne puis se rapproche, si bien que la tension monte jusqu'à une valeur maximale Vₘₐₓ, en passant éventuellement par des bosses définissant une valeur minimale Vₘᵢₙ intermédiaire entre deux maxima successifs, puis diminue jusqu'à sa valeur initiale Vₒ. La fin t₁ de la phase d'apprentissage est définie quand la tension atteint une valeur V₁ voisine de Vₒ et légèrement supérieure à Vₒ. La valeur d'extremum vₘ est prise égale à vₘₐₓ ou vₘᵢₙ ou à une combinaison de ces valeurs et v_{c} est calculée comme précédemment en fonction de vₒ et vₘ. Les valeurs v_{c} et vₕ sont stockées comme précédemment dans la mémoire 18 si les moyens de validation ont constaté que la mesure n'est pas restée confinée dans la zone aveugle d'étalonnage Z.

La logique 17 détermine automatiquement si le calcul de la valeur vc doit s'effectuer en considérant que la cible est initialement distante ou proche. La séquence du traitement exécuté par la logique comprend alors les étapes suivantes (voir figure 5) : étape 40 d'acquisition des valeurs vₒ et vₘ₁,vₘ₂, étape 41 d'analyse des paramètres pour désigner la cible comme étant initialement proche ou distante et étape 42 de calcul adapté, c'est-à-dire tenant compte de la désignation de cible opérée dans l'étape 41, de la valeur de commutation v_{c}.

Le fonctionnement du détecteur selon l'invention va être expliqué en regard des figures et, en particulier, de la figure 4, pour une cible initialement distante.

A la mise sous tension du détecteur 30 commence une séquence de fonctionnement de celui-ci. Selon que la réponse à la question "étalonnage effectué" posée dans une étape 31 est oui ou non, la logique de traitement va fonctionner après une temporisation 32 selon une séquence 34 en mode détection ou selon une séquence 33 en mode apprentissage. Dans ce dernier cas, dès que la phase d'apprentissage est achevée et validée, le détecteur est commuté en mode détection. A tout moment peut être appliqué le signal d'apprentissage RZ pour commuter en 35 du mode détection au mode apprentissage et déclencher une nouvelle phase d'apprentissage conduisant au réétalonnage du détecteur.

Ainsi, lorsque la source d'énergie est connectée aux bornes 12, la tension d'alimentation de l'organe capteur 11 augmente jusqu'à V⁺ et la tension délivrée par l'organe capteur atteint la valeur Vₒ. Au bout d'une temporisation par exemple de 100 ms, le circuit 20 délivre le signal R à la logique de traitement.

Lorsque la tension V atteint la valeur V₁ voisine de la valeur initiale Vₒ, les moyens de validation déterminent la fin de la phase d'apprentissage et les valeurs de commutation v_{c} et d'hystérésis vₕ sont stockées dans la mémoire EEPROM 18. Le détecteur passe alors en mode détection 34 et l'organe de visualisation indique par son état non clignotant l'état de commutation ; à l'approche d'une cible, la valeur minimale de la tension qui en résulte est comparée à la valeur v_{c} lue dans la mémoire pour que le circuit de traitement engendre un signal de présence d'objet.

Il convient d'observer que la durée t₁-t₀ de la phase d'apprentissage n'est pas fixe et est déterminée par le processus d'approche et d'éloignement de la cible.

## Revendications

1. Détecteur de proximité (D) comprenant :
- un organe capteur (11) apte à délivrer à un circuit électronique de traitement (14) un signal analogique en fonction de la distance d'une cible (A),
- le circuit électronique de traitement (14) étant relié à un étage de sortie (15) qui délivre un signal de présence ou d'absence de cible selon que la distance de celle-ci est inférieure ou supérieure à une distance de commutation (X_{c}),
- le circuit électronique de traitement (14) étant conçu pour fonctionner selon un mode d'apprentissage et un mode de détection et comprenant une mémoire non volatile (18) qui mémorise une valeur de commutation (v_{c}) acquise en mode apprentissage, cette valeur étant lue en mode détection,
caractérisé par le fait que :
- le circuit de traitement (14) comporte des moyens de numérisation (16) du signal analogique et des moyens d'acquisition et de calcul (17a) inclus dans une logique (17) commandée par un signal d'apprentissage,
- les moyens d'acquisition et de calcul (17a) étant mis en oeuvre dans une phase d'apprentissage et saisissant au début (tₒ) de la phase d'apprentissage une valeur initiale (vₒ) du signal numérique de détection, significative d'une position initiale de la cible déplaçable, et au cours de la phase d'apprentissage une valeur extrémale (vₘ) dudit signal, significative d'une position intermédiaire de la cible, et calculant la valeur de commutation (v_{c}) en fonction de la valeur initiale (vₒ) et de la valeur extrémale (vₘ),
- la logique (17) déterminant la fin (t₁) de la phase d'apprentissage quand la valeur du signal de détection atteint une valeur qui est significative du retour de la cible à une position proche de la position initiale.

2. Détecteur de proximité selon la revendication 1, caractérisé par le fait que que le début (tₒ) de la phase d'apprentissage est engendré à compter de la première application de la tension d'alimentation au détecteur.

3. Détecteur de proximité selon la revendication 1, caractérisé par le fait que le début (tₒ) de la phase d'apprentissage est engendré par l'application d'un signal externe (RZ) à une borne du détecteur.

4. Détecteur de proximité selon l'une des revendications 1 à 3, caractérisé par le fait que des moyens de validation (17b) invalident les moyens d'acquisition et de calcul (17a) lorsque la valeur extrémale (vₘ) est comprise dans une zone aveugle d'étalonnage (Z).

5. Détecteur de proximité selon l'une des revendications 1 à 4, caractérisé par le fait que les moyens d'acquisition et de calcul (17a) calculent la valeur de commutation (v_{c}) en fonction de la différence (vₒ-vₘ) entre la valeur initiale (vₒ) et la valeur extrémale (vₘ) du signal numérique et du signe de cette différence et adaptent le calcul à la position initiale de la cible.

6. Détecteur de proximité selon l'une des revendications 1 à 5, caractérisé par le fait que la valeur extrémale (vₘ) est la valeur minimale (vₘᵢₙ) ou maximale (vₘₐₓ) relevée au cours de la phase d'apprentissage.

7. Détecteur de proximité selon l'une des revendications 1 à 5, caractérisé par le fait que la valeur extrémale (vₘ) est la valeur intermédiaire maximale (vₘₐₓ) ou minimale (vₘᵢₙ) relevée entre deux minima ou respectivement maxima (vₘ₁,vₘ₂) au cours de la phase d'apprentissage.

8. Détecteur de proximité selon l'une des revendications 1 à 7, caractérisé par le fait que la logique de traitement (17) est reliée à un organe de visualisation (19) permettant de distinguer visuellement le mode d'apprentissage du mode de détection.

9. Détecteur de proximité selon l'une des revendications 1 à 8, caractérisé par le fait que la logique de traitement (17) détermine dans la phase d'apprentissage une valeur numérique d'hystérésis (vₕ) qui est fonction des valeurs initiale (vₒ) et extrémale (vₘ) et qui est mémorisée dans la mémoire non volatile (18).

## Patentansprüche

1. Näherungsschalter (D) mit:
- einem Fühlerorgan (11), das an einen elektronischen Verarbeitungskreis (14) ein analogisches Signal entsprechend der Entfernung eines Ziels (A) liefern kann,
- wobei der elektronische Verarbeitungskreis (14) mit einer Ausgangsstufe (15) verbunden ist, die ein Präsenz- oder Abwesenheitssignal des Ziels liefert, je nachdem, ob seine Entfernung kleiner oder grösser ist als eine Umschaltentfernung (Xc),
- wobei der elektronische Verarbeitungskreis (14) ausgelegt ist, um nach einem Lernmodus und einem Detektionsmodus zu funktionieren, und einen nicht flüchtigen Speicher (18) umfasst, der einen im Lernmodus erfassten Umschaltwert (v_{c}) speichert, wobei dieser Wert im Detektionsmodus ausgelesen wird,
dadurch gekennzeichnet, dass:
- der Verarbeitungskreis (4) Digitalisierungsmittel (16) des analogischen Signals und Erfassungs- und Berechnungsmittel (17a) innerhalb einer von einem Lernsignal gesteuerten Logik (17) umfasst,
- wobei die Erfassungs- und Berechnungsmittel (17a) in einer Lernphase zum Einsatz gelangen und am Anfang (tₒ) der Lernphase einen ursprünglichen Wert (vₒ) des digitalen Detektionssignals erfassen, der für eine ursprüngliche Position des verschiebbaren Ziels steht, und während der Lernphase einen Extremwert (vₘ) des besagten Signals, der für eine Zwischenposition des Ziels steht, und den Umschaltwert (v_{c}) entsprechend des ursprünglichen Werts (vₒ) und des Extremwerts (vₘ) berechnet,
- wobei die Logik (17) das Ende (t₁) der Lernphase bestimmt, wenn der Wert des Detektionssignals die Rückkehr des Ziels zu einem Wert in der Nähe des Ursprungswerts (vₒ) darstellt.

2. Näherungsschalter nach Anspruch 1, dadurch gekennzeichnet, dass der Anfang (tₒ) der Lernphase ab der ersten Beaufschlagung des Detektors mit der Versorgungsspannung erzeugt wird.

3. Näherungsschalter nach Anspruch 1, dadurch gekennzeichnet, dass der Anfang (tₒ) der Lernphase durch das Anlegen eines externen Signals (RZ) an eine Klemme des Detektors erzeugt wird.

4. Näherungsschalter nach einem der Ansprüche 1 bis 3, dadurch gekennzeichnet, dass Validationsmittel (17b) die Erfassungs- und Berechnungsmittel (17a) ungültig machen, wenn der Extremwert (vₘ) innerhalb einer blinden Eichzone (Z) liegt.

5. Näherungsschalter nach einem der Ansprüche 1 bis 4, dadurch gekennzeichnet, dass die Erfassungs- und Berechnungsmittel (17a) den Umschaltwert (v_{c}) entsprechend der Differenz (vₒ-vₘ) zwischen dem ursprünglichen Wert (vₒ) und dem Extremwert (vₘ) des digitalen Signals und dem Vorzeichen dieser Differenz berechnen und die Berechnung an die ursprüngliche Position des Ziels anpassen.

6. Näherungsschalter nach einem der Ansprüche 1 bis 5, dadurch gekennzeichnet, dass der Extremwert (vₘ) der minimale (vₘᵢₙ) oder maximale (vₘₐₓ) während der Lernphase aufgezeichnete Wert ist.

7. Näherungsschalter nach einem der Ansprüche 1 bis 5, dadurch gekennzeichnet, dass der Extremwert (vₘ) der maximale (vₘₐₓ) oder minimale (vₘᵢₙ) Zwischenwert ist, der zwischen zwei Minima bzw. Maxima (vₘ₁, vₘ₂) während der Lernphase aufgezeichnet wurde.

8. Näherungsschalter nach einem der Ansprüche 1 bis 7, dadurch gekennzeichnet, dass die Verarbeitungslogik (17) an ein Visualisierungsorgan (19) angeschlossen ist, das eine visuelle Unterscheidung zwischen dem Lernmodus und dem Detektionsmodus ermöglicht.

9. Näherungsschalter nach einem der Ansprüche 1 bis 8, dadurch gekennzeichnet, dass die Verarbeitungslogik (17) während der Lernphase einen digitalen Hysteresewert (vₕ) bestimmt, der Funktion des ursprünglichen Werts (vₒ) und des Extremwerts (vₘ) ist und im nicht flüchtigen Speicher (18) gespeichert wird.

## Claims

1. Proximity detector (D) comprising:
- a sensor device (11) capable of outputting an analog signal to an electronic processing circuit (14), depending on the distance from a target (A).
- the electronic processing circuit (14) being connected to an output stage (15) that outputs a target present or missing signal depending on whether the distance is less than or greater than a switching distance (X_{c}),
- the electronic processing circuit (14) being designed to operate in a learning mode and a detection mode, and comprising a non-volatile memory (18) that memorizes a switching value (V_{c}) acquired in learning mode, this value being read in detection mode,
characterized by the fact that:
- the processing circuit (14) comprises means (16) of digitizing the analog signal, and acquisition and calculation means (17a) included in logic (17) controlled by a learning signal,
- the acquisition and calculation means (17a) being used in a learning phase and at the beginning of the learning phase (t₀) inputting an initial value (vₒ) of the digital detection signal corresponding to an initial position of the movable target, and during the learning phase an extreme value (vₘ) of the said signal corresponding to an intermediate position of the target, and calculating the switching value (v_{c}) as a function of the initial value (vₒ) and the extreme value (vₘ),
- the logic (17) determining the end (t₁) of the learning phase when the value of the detection signal corresponds to the target being returned to a value close to its initial value (vₒ).

2. Proximity detector according to claim 1, characterized by the fact that the beginning (t₀) of the learning phase is triggered when the power supply voltage is applied to the detector for the first time.

3. Proximity detector according to claim 1, characterized by the fact that the beginning (t₀) of the learning phase is triggered by application of an external signal (RZ) to a terminal of the detector.

4. Proximity detector according to one of claims 1 to 3, characterized by the fact that the validation means (17b) invalidate the acquisition and calculation means (17a) when the extreme value (vₘ) is included within a blind calibration area (Z).

5. Proximity detector according to any one of claims 1 to 4, characterized by the fact that the acquisition and calculation means (17a) calculate the switching value (v_{c}) as a function of the difference (vₒ-vₘ) between the initial value (vₒ) and the extreme value (vₘ) of the digital signal and the sign of this difference, and adapt the calculation to the initial position of the target.

6. Proximity detector according to any one of claims 1 to 5, characterized by the fact that the extreme value (vₘ) is the minimum value (vₘᵢₙ) or the maximum value (vₘₐₓ) recorded during the learning phase.

7. Proximity detector according to any one of claims 1 to 5, characterized by the fact that the extreme value (vₘ) is the maximum intermediate value (vₘₐₓ) or the minimum intermediate value (vₘᵢₙ) recorded between two minima or two maxima respectively (vₘ₁, vₘ₂) during the learning phase.

8. Proximity detector according to any one of claims 1 to 7, characterized by the fact that the processing logic (17) is connected to a display device (19) in order to visually distinguish learning mode from detection mode.

9. Proximity detector according to any one of claims 1 to 8, characterized by the fact that the processing logic (17) determines a digital hysteresis value (vₕ) during the learning phase, which is a function of the initial value (vₒ) and the extreme value (vₘ), which is stored in non-volatile memory (18).
